(19) **Europäisches Patentamt / European Patent Office / Office européen des brevets**

(11) **EP 3 427 556 B1**

(12) **FASCICULE DE BREVET EUROPEEN**

(45) Date de publication et mention de la délivrance du brevet:
**13.05.2020 Bulletin 2020/20**

(51) Int Cl.:
**H05K 1/02** *(2006.01)*

(21) Numéro de dépôt: **17727303.4**

(86) Numéro de dépôt international:
**PCT/FR2017/051161**

(22) Date de dépôt: **12.05.2017**

(87) Numéro de publication internationale:
**WO 2017/194899 (16.11.2017 Gazette 2017/46)**

(54) **CIRCUIT ÉLECTRONIQUE**

**ELEKTRONISCHE SCHALTUNG**

**ELECTRONIC CIRCUIT**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.05.2016 FR 1654275**

(43) Date de publication de la demande:
**16.01.2019 Bulletin 2019/03**

(73) Titulaire: **Zodiac Aerotechnics**
**78370 Plaisir (FR)**

(72) Inventeur: **RACIC, Zoran**
**75003 Paris (FR)**

(74) Mandataire: **Plasseraud IP**
**66, rue de la Chaussée d'Antin**
**75440 Paris Cedex 09 (FR)**

(56) Documents cités:
**EP-A1- 2 448 390    US-A1- 2014 004 723**

**Description**

La présente invention se situe dans le domaine de la gestion des données d'entrée/sortir de circuits électroniques.

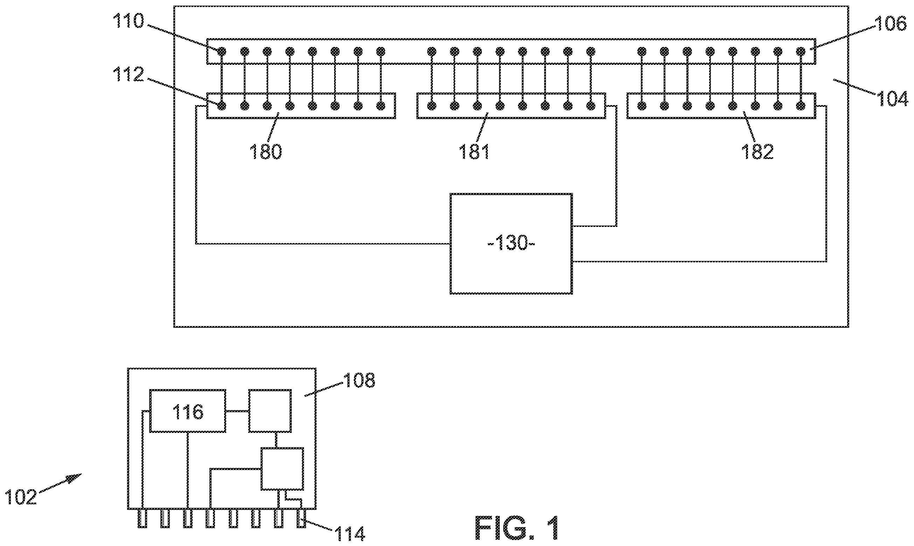

Le document EP 2448390 divulgue une carte électronique de fond de panier d'un équipement électronique comportant des moyens de renforts contre les vibrations. Le document US 2014/004723 divulgue un ensemble de cartes filles comportant un dispositif de guidage facilitant le couplage avec une carte mère. En particulier, la présente invention concerne des circuits électroniques utilisés dans le domaine de l'aéronautique. Dans ce domaine, chaque circuit électronique est conçu spécifiquement en fonction des besoins de l'avionneur. En référence à la figure 1, un circuit électronique 102 comporte par exemple une carte électronique mère 104, un connecteur d'entrée sortie 106, une unité de calcul principale 130, des connecteurs d'extension 180, 181 et 182 et des cartes d'extension 108. Le connecteur d'entrée/sortie 106 comporte des contacts d'entrée/sortie 110 propres à recevoir/transmettre des données d'entrées/sorties. Les connecteurs d'extension 180, 181 et 182 comportent des contacts d'extension 112 reliés électriquement aux contacts d'entrée/sortie 110. Les cartes d'extension 108 sont munies de broches de contact 114 enfichées dans les connecteurs d'extension 180, 181, 182. Des composants électroniques 116 sont montées sur les cartes d'extension 108 et sont reliés électriquement aux broches 114. Les cartes d'extension 108 sont développées pour réaliser une fonction au sein du circuit électronique tel que par exemple un calcul de température ou de position. Les résultats des fonctions mises en œuvre par les cartes d'extension 108 sont transmis à l'unité de calcul principal 130 par des liaisons électriques. Lorsque l'avionneur souhaite ajouter une fonctionnalité supplémentaire à un circuit électronique existant ou s'il souhaite modifier une fonctionnalité, par exemple, pour adapter le circuit à une gamme d'avions ou tout simplement pour répondre à une commande spécifique d'un client, l'ensemble de la carte électronique doit être à nouveau développé car dans la plus part des cas l'ensemble des contacts d'entrée/sortie 110 est déjà connecté à un contact d'extension 112. Lorsque l'ensemble des contacts d'extension 112 est déjà utilisé, il faut redévelopper une nouvelle carte mère 104. Ce développement est long. Le développement d'un circuit électronique ou d'une carte d'extension est coûteux.

Le but de la présente invention est de concevoir une carte électronique ayant une architecture standard sur laquelle de nouvelles fonctions peuvent être facilement et rapidement implémentés ou sur laquelle des fonctions peuvent être facilement modifiées.

A cet effet, l'invention a pour objet, un circuit électronique comprenant comprenant :

    a) une carte électronique mère,
    b) un connecteur d'entrée/sortie fixé sur la carte électronique mère, ledit connecteur d'entrée/sortie comprenant au moins un groupe comportant N contacts d'entrée/sortie, N étant un entier naturel supérieur ou égal à 2 ;

    c) au moins un ensemble comportant des connecteurs d'extension fixés sur la carte électronique mère, chaque connecteur d'extension du au moins un ensemble ayant des contacts d'extension connectés électriquement à des contacts d'entrée/sortie du au moins un groupe;

chaque contact d'entrée/sortie du au moins un groupe étant identifié par un identifiant T, chaque connecteur d'extension du au moins un ensemble étant identifié par un identifiant S, chaque contact d'extension connecté étant identifié par un identifiant R, les identifiants T, R et S étant des nombres entiers naturels supérieur ou égale à 0; caractérisé en ce que, pour :

- chaque connecteur d'extension d'identifiant S du au moins un ensemble, et
- chaque contact d'extension connecté d'identifiant R,

chaque contact d'entrée/sortie d'identifiant T du au moins un groupe est relié électriquement à un unique contact d'extension d'identifiant R du connecteur d'extension d'identifiant S du au moins un groupe, et en ce que l'identifiant T du contact d'entrée/sortie du au moins un groupe est calculé en fonction des identifiants R et S selon la relation suivante :

$$T = [(R + D \times S) \bmod (N)]$$

avec D fixé dans chaque groupe et sous multiple entier de l'entier naturel N.

Avantageusement, le circuit électronique selon l'invention permet de concevoir une carte électronique et d'adapter cette conception tout au long du développement des circuits électroniques de l'avion.

Avantageusement, un circuit électronique conçu selon l'invention peut s'adapter facilement à différents types d'avion.

Suivant des modes particuliers de réalisation, le circuit électronique comporte l'une ou plusieurs des caractéristiques suivantes, prises isolément ou en combinaison :

- qui comporte au moins une carte d'extension comprenant au moins un composant électronique et au moins une broche de contact reliée électriquement audit composant électronique, ladite au moins une broche de contact étant disposée à une extrémité de la carte d'extension et enfichée dans au moins un contact d'extension d'au moins un connecteur d'extension, et dans lequel l'entier naturel D est inférieur ou égal audit nombre broche de contact.

- dans lequel ledit au moins un composant électronique est relié à plusieurs broches de contact, lesdites broches de contact étant situées les unes directement adjacentes aux autres.
- dans lequel les contacts d'extension sont identifiés par des identifiants selon un ordre croissant de gauche à droite ou de droite à gauche et dans lequel le connecteur d'extension connecté directement au connecteur d'entrée/sortie, dit premier connecteur d'extension, présente un identifiant S égal à 0, ledit connecteur d'extension directement relié audit premier connecteur d'extension ayant un identifiant S égal à 1.
- dans lequel l'identifiant S varie entre 0 et au moins (N / D) - 1.
- dans lequel l'entier naturel D est égal à 1.
- dans lequel l'entier naturel D est égal à 2.
- dans lequel l'entier naturel D est égal à 4.
- dans lequel le connecteur d'entrée/sortie est intégré à l'unité de calcul.
- qui comporte au moins deux ensembles, les contacts d'extension d'un ensemble étant reliés électriquement aux contacts d'entrée/sortie d'un groupe,

et dans lequel les connecteurs d'extension sont disposés sur la carte électronique mère selon un arrangement en quadrillage,

lesdits connecteurs d'extension d'un même ensemble étant alignés le long d'une première droite rectiligne ; au moins deux connecteurs d'extension de deux ensembles distincts étant alignés le long d'une seconde droite rectiligne qui s'étend perpendiculairement à la première droite rectiligne.

- qui comporte au moins une carte d'extension enfichée dans au moins un connecteur d'extension, ladite carte d'extension s'étendant perpendiculairement à la carte mère.
- qui comporte au moins une carte d'extension enfichée dans au moins un connecteur d'extension, ladite carte d'extension s'étendant parallèlement à la carte mère.

L'invention sera mieux comprise à la lecture de la description qui va suivre, donnée uniquement à titre d'exemple et faite en se référant aux figures sur lesquelles :

- la figure 1 est une vue schématique de face d'un circuit électronique selon l'état de la technique ;
- la figure 2 est une vue schématique de face d'un premier exemple de circuit électronique selon la présente invention ;
- la figure 3 est une vue schématique de trois cartes d'extension du circuit électronique selon la présente invention ;
- la figure 4 est une vue schématique de face du circuit électronique représenté sur la figure 1 dans lequel une fonction est réalisée deux fois ;
- la figure 5 est une vue schématique d'un circuit électronique de face d'un deuxième exemple de circuit électronique selon la présente invention ;
- la figure 6 représente une vue en perspective d'un troisième exemple de circuit électronique selon la présente l'invention.

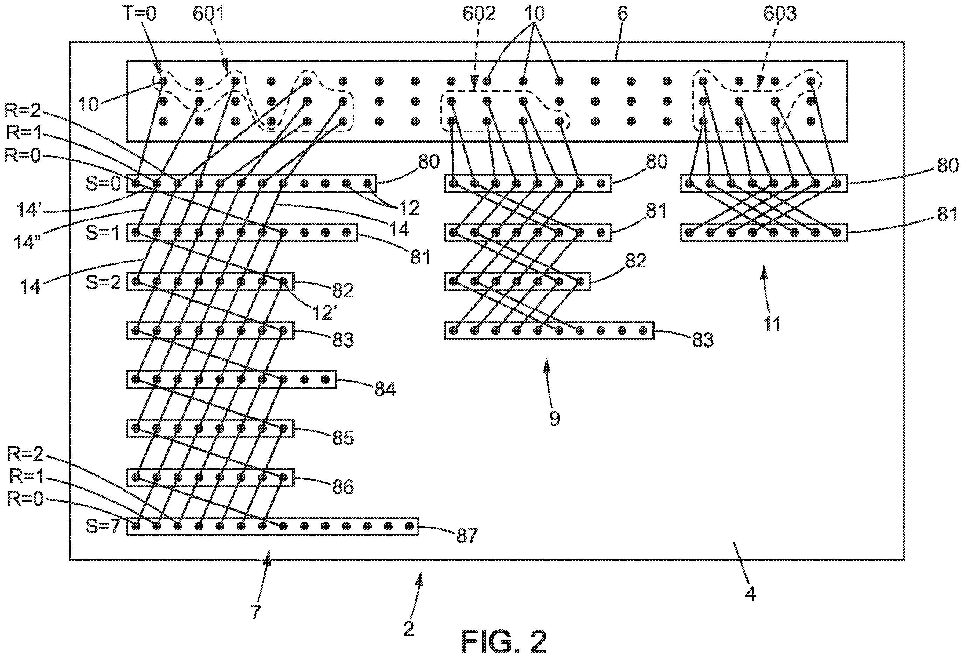

La figure 2 représente un exemple de réalisation de l'invention. Cet exemple de réalisation n'est nullement limitatif.

En référence à la figure 2, le circuit électronique 2 comporte une carte mère 4, un connecteur d'entrée/sortie 6 un premier 7, un deuxième 9 et un troisième 11 ensembles de connecteurs d'extension 80 à 87 fixés sur la carte mère 4.

Le connecteur d'entrée/sortie 6 comprend un premier 601, un deuxième 602 et un troisième 603 groupes de contacts d'entrée/sortie 10. Chaque groupe comprend N contacts d'entrée/sortie. N est un entier naturel supérieur ou égal à 2

Par exemple dans le mode de réalisation illustré sur la figure 2, le premier groupe 601 comprend 8 contacts d'entrée/sortie 10. Dans le premier groupe, l'entier naturel N est donc égal à 8. Le deuxième groupe 602 comprend 7 contacts d'entrée/sortie 10. L'entier naturel N est donc égal à 7 dans le deuxième groupe. Le troisième groupe 603 comprend 8 contacts d'entrée/sortie 10. L'entier naturel N est égal à 8 dans le troisième groupe.

Pour les besoin de la présente demande de brevet, chaque contact d'entrée/sortie 10 d'un groupe est identifié par un identifiant T. Les identifiants T sont des nombres entiers naturels supérieurs à 0. Dans chaque groupe 601, 602, 603, les identifiants T commencent à 0. Puis, ils croissent d'une unité. Ce sont des nombres consécutifs. L'attribution des identifiants T aux contacts d'entrée/sortie 10 d'un groupe, est indépendante de leur localisation sur le connecteur d'entrée/sortie 6.

Les connecteurs d'extension 80 à 87 comprennent des contacts d'extension 12. Chaque connecteur d'extension 80 à 87 peut avoir un nombre différent de contacts d'extension 12.

Les contacts d'extension 12 des connecteurs d'extension 80 à 87 d'un ensemble donné sont reliés électriquement aux contacts d'entrée/sortie 10 d'un groupe.

Ainsi, sur la figure 2, les contacts d'extension 12 des connecteurs d'extension 80 à 87 du premier ensemble 7 sont reliés électriquement aux contacts d'entrée/sortie 10 du premier groupe 601. Les contacts d'extension 12 des connecteurs d'extension 80 à 83 du deuxième ensemble 9 sont reliés électriquement aux contacts d'entrée/sortie 10 du deuxième groupe 602. Enfin, les contacts d'extension 12 des connecteurs d'extension 80 et 81 du troisième ensemble 11 sont reliés électriquement aux contacts d'entrée/sortie 10 du troisième groupe 603.

Dans un même ensemble 7, 9, 11, les contacts d'extension 12 d'un connecteur d'extension 80 sont connectés aux contacts d'extension 12 d'un autre connecteur d'extension 81 par des liaisons électriques 14.

Pour les besoin de la présente invention, les connecteurs d'extension 80 à 87 sont identifiés par un identifiant S. Les contacts d'extension 12 sont identifiés par un identifiant R. Les identifiants R et S sont des nombres entiers naturels supérieur ou égal à zéro. Les identifiants R commencent à zéro. Puis, ils croissent d'une unité. Ce sont des nombres consécutifs.

De même, les identifiants S commencent à zéro. Puis, ils croissent d'une unité. Les identifiants S sont également des nombres consécutifs. Les identifiants S des connecteurs d'extension de chaque ensemble 7, 9, 11 sont compris entre 0 et (N divisé par D) -1, avec D entier naturel fixé pour chaque groupe et D sous multiple entier de l'entier naturel N. Un sous multiple est un nombre qui se trouve compris plusieurs fois exactement dans un nombre plus grand.

Pour l'application de la présente invention, le connecteur d'extension directement relié au connecteur d'entrée/sortie 6 est identifié avec l'identifiant le plus faible, c'est-à-dire l'identifiant égal à zéro. Il est appelé ci-après premier connecteur d'extension 80. Le premier connecteur d'extension 80 porte l'identifiant S=0.

Le connecteur d'extension 81 directement relié électriquement au premier connecteur d'extension 80 porte un identifiant égal à l'identifiant le plus faible additionné d'une unité. Le terme « relié directement » signifie ici sans intermédiaire. Ainsi, le connecteur d'extension 81 porte l'identifiant S=1. Il est appelé deuxième connecteur d'extension 81.

Le connecteur d'extension 82 directement relié au deuxième connecteur d'extension 81 porte un identifiant égal à l'identifiant le plus faible additionné de deux unités. Il porte l'identifiant S=2. Il est appelé, dans la présente demande de brevet, troisième connecteur d'extension.

Les autres identifiants des connecteurs d'extension du premier ensemble 7 sont attribués en utilisant la même règle.

De la même façon, les identifiants des connecteurs d'extension du second ensemble 9 sont attribués en utilisant la même règle de telle façon que le connecteur d'extension 80 directement relié au connecteur d'entrée sortie 6 porte l'identifiant égal à zéro. Le connecteur d'extension 81 directement relié électriquement au premier connecteur d'extension 80, porte l'identifiant S=1 et ainsi de suite.

Les identifiants R sont attribués aux contacts d'extension 12 de chaque connecteur d'extension de gauche à droite en commençant par l'identifiant égal à zéro et en terminant par l'identifiant le plus élevé.

Ainsi, chaque contact d'extension d'un connecteur d'extension est défini par un couple d'identifiants comprenant S et R. Par exemple, le contact d'extension référencé 12' sur la figure 2 est identifié par le couple S=2 et R =8.

Selon la présente invention, pour :

- chaque connecteur d'extension d'identifiant S d'un ensemble 7, 9, 11, et
- chaque contact d'extension connecté d'identifiant R de cet ensemble 7, 9, 11,

chaque contact d'entrée/sortie 10 d'identifiant T d'un groupe 601, 602, 603 est relié électriquement à un unique contact d'extension 12' d'identifiant R du connecteur d'extension d'identifiant S,
et l'identifiant T du contact d'entrée/sortie 10 de ce groupe 601, 602 603 est calculé en fonction des identifiants R et S selon la relation suivante :

$$T = [(R + D \times S) \bmod (N)] \qquad (1)$$

Dans laquelle D est un entier naturel fixé pour chaque groupe et D est un sous multiple entier de l'entier naturel N.

Un contact d'extension connecté est un contact d'extension relié électriquement soit à un autre contact d'extension soit à un contact d'entrée/sortie.

Cette relation mathématique est réalisée lorsque l'on utilise la méthode d'attribution des identifiants mentionnée ci-dessus.

Dans chaque ensemble, chaque liaison électrique 14 entre deux connecteurs d'extension identifiés par des identifiants successifs croise D ou B-D autres liaison(s) électrique(s) 14 entre ces deux mêmes connecteurs d'extension, avec B le nombre de contact d'extension connecté.

Dans le premier ensemble 7, le nombre D est égal à un. Ainsi, la liaison électrique 14' entre le deuxième connecteur d'extension 81 et le troisième connecteur d'extension 82 du premier ensemble 7 croise sept autres liaisons électriques 14 entre ces mêmes connecteurs 81,82 et la liaison électrique 14" entre le premier connecteur d'extension 81 et le deuxième connecteur d'extension 82 du premier ensemble 7 croise une autre liaison électrique entre ces mêmes connecteurs 81 et 82 (dans ce cas S=0, S=1, N = 8, et D=1).

Dans le deuxième ensemble 9, le nombre D est égal à deux.

Dans le troisième ensemble 11, le nombre D est égal à quatre.

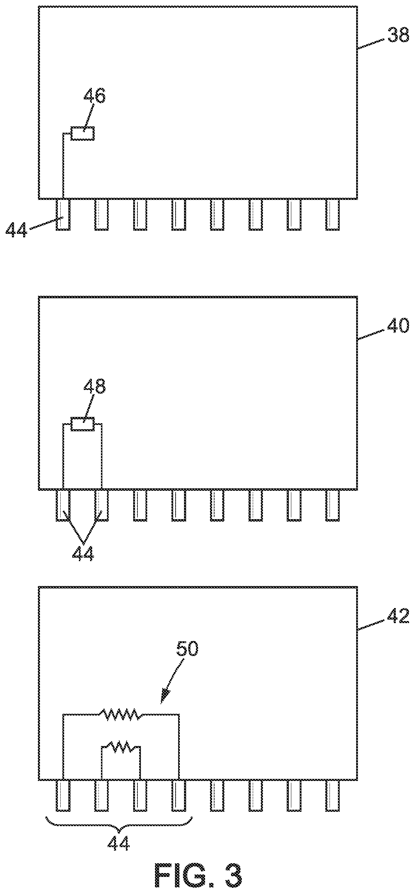

Le circuit électronique 2 selon la présente invention comporte des cartes d'extension 38, 40, 42 propres à être enfichées dans les connecteurs d'extension 80 à 87. Ces cartes d'extension 38, 40, 42 peuvent être des cartes standard par exemple à huit broches de contact 44, comme illustré sur la figure 3.

Selon la présente invention, les composants électroniques 46, 48, 50 montés sur les cartes d'extension sont connectés à une ou plusieurs broches de contacts d'extrémité. Lorsque les composants électroniques d'une carte d'extension sont connectés à plusieurs broches de contact, les broches d'extrémité connectées aux composants électroniques sont disposées consécutivement les unes à côté des autres.

Dans l'exemple illustré sur la figure 3, les composants électroniques 46, 48, 50 sont connectés aux broches de contacts 44 d'extrémité de droite. En variante, les composants électroniques sont connectés aux broches de contacts d'extrémité de gauche.

Les cartes d'extensions 38 ayant un ou plusieurs composants électroniques connectés à une seule broche de contact 44 sont connectées dans l'ensemble de connecteur d'extension dans lequel D est égal à un. Dans l'exemple de réalisation des figures 2 et 3, la carte d'extension 38 comporte un générateur 46 d'un signal discret de puissance connecté à une broche de contact 44. Cette carte d'extension 38 est propre à être enfichées dans un des connecteurs d'extension du premier ensemble 7.

Les cartes d'extensions 40 ayant un ou plusieurs composants électroniques connectés à deux broches de contact sont connectées dans le groupe de connecteur d'extension défini par D égal à deux. Dans l'exemple de réalisation des figures 2 et 3, la carte d'extension 40 comporte un voltmètre 48 connecté à deux broches de contact 44. La carte d'extension 40 est apte à être connectée dans un des connecteurs d'extension du deuxième ensemble 9.

Enfin, les cartes d'extensions 42 ayant un ou plusieurs composants électroniques connectés à quatre broches de contact sont connectées dans le groupe de connecteur d'extension défini par D égal à quatre. Dans l'exemple de réalisation des figures 2 et 3, la carte d'extension 42 comporte un composant électronique 50 propre à réaliser une mesure de résistance de précision connecté à quatre broches de contact 44. La carte d'extension 42 est apte à être connectée dans un des connecteurs d'extension du troisième ensemble 11.

Les cartes d'extension peuvent comprendre des composants électroniques connectés à un nombre impair de broches de contact. Par exemple, lorsqu'un potentiomètre est monté sur une carte d'extension, trois broches de contact sont connectées au potentiomètre.

Lors du développement de la carte électronique selon la présente invention, le développeur choisit l'entier naturel N ainsi que l'entier naturel D associé à chaque ensemble en fonction des fonctions qui sont_fréquemment utilisées en aéronautique et du nombre de broches de contacts qui seront implémentées pour réaliser ces fonctions.

Par exemple, le développeur peut choisir de réaliser quatre ensembles avec D=0 (connexions directes), D= 1, D=2 et D=4.

Le choix de D est fonction du nombre de broches de contact qui seront connectées pour réaliser une fonction. Ainsi, on choisit de faire un ensemble dans lequel D= 1, lorsque l'on sait que l'on aura plusieurs fonctions ou composant électronique reliés à une seule broche de contact 44. Si on pense avoir besoin d'un grand nombre de fonctions à une seule broche on choisit P-et N important par exemple N = 8.

Le nombre N est fonction du nombre de broches disponibles sur le connecteur d'extension et du nombre de broches de contact déjà utilisées pour d'autres fonctions. Avantageusement, le nombre N correspond au nombre de contact d'extension de connecteur d'extension standard et au nombre de broche de cartes d'extension standard de manière à diminuer les coûts de production et les délais de livraison

Par exemple, on peut concevoir un circuit électronique avec N =8, un premier groupe avec D=1, un deuxième groupe avec D=2 et un troisième groupe avec D=4, comme le circuit électronique 2 illustré sur la figure 2.

En variante, les identifiants R sont attribués aux contacts d'extension 12 de chaque connecteur d'extension de droite à gauche en commençant par l'identifiant le plus faible et en terminant par l'identifiant le plus élevé.

Cette manière de réaliser des connexions électriques permet de modifier des fonctions réalisées par la carte électronique sans avoir à refaire la carte électronique complètement.

Ainsi par exemple si la carte électronique 4 est initialement destinée à réceptionner quatre cartes d'extension 38 qui sont destinées à être enfichées dans le premier 80, le deuxième 81, le troisième 82 et le cinquième 84 connecteurs d'extension du premier ensemble 7.

La carte d'extension enfichée dans le premier connecteur d'extension 80 (S= 0) traite les signaux entrant et/ou sortant du contact d'extension 12 identifié par R=0. La carte d'extension enfichée dans le deuxième connecteur d'extension 81 (S= 2) traite les signaux entrant et/ou sortant du contact d'extension identifié R=1. Le signal réceptionné par le contact d'extension 12 identifié par R=0 et S=1 n'a pas été utilisé par le premier connecteur d'extension 80.

La carte d'extension enfichée dans le troisième connecteur d'extension 82 (S=3) traite les signaux entrant et/ou sortant du contact d'extension identifié R= 3. La carte d'extension enfichée dans le sixième connecteur d'extension 85 traite les signaux entrant et/ou sortant du contact d'extension identifié R= 0.

Si l'avionneur souhaite ajouter une fonction supplémentaire mise en œuvre par un ou plusieurs composants électroniques connectés à une broche de contact, il pourra enficher une nouvelle carte d'extension dans les connecteurs d'extension identifiés par S= 3, S=5 ou S=6.

Si l'avionneur souhaite retirer une carte d'extension d'un connecteur d'extension particulier, par exemple la carte d'extension enfichée dans le premier connecteur d'extension 80 du premier ensemble, cette modification peut être réalisée sans que cela affecte les autres cartes d'extension. Dans le cas d'un tel retrait, le contact d'entrée/sortie 10 identifié par T=0 et le contact d'extension identifié par S=0 et R=0 sont rendus disponibles pour l'ajout d'une nouvelle carte d'extension.

Ainsi, avantageusement, la suppression d'une carte d'extension n'entraîne pas de perte de point de connexion sur le connecteur d'entrée/sortie 6.

Une ou plusieurs cartes d'extension ayant deux broches de contacts connectées à des composants électronique peuvent également être enfichées dans les connecteurs d'extension du premier ensemble 7. Mais dans ce cas, le connecteur d'extension suivant et directement relié à ce connecteur d'extension ne peut pas réceptionner une carte d'extension.

Par exemple, si une première carte d'extension 40 ayant deux broches de contact connectées est enfichées dans le premier connecteur d'extension 80 (S=0), le signal réceptionné par le contact d'extension identifié par S=1 et R=0 sera déjà défini en fonction des besoins de la carte d'extension enfichée dans le premier connecteur d'extension 80, il ne pourra donc pas être utilisé par une carte d'extension enfichée dans le deuxième connecteur d'extension 81 sauf si cette dernière utilise le même signal que celui fourni au contact d'extension identifié par S=0 et R=1. Généralement dans un tel cas, une deuxième carte d'extension sera enfichée dans le troisième connecteur d'extension 82 identifié par S=2.

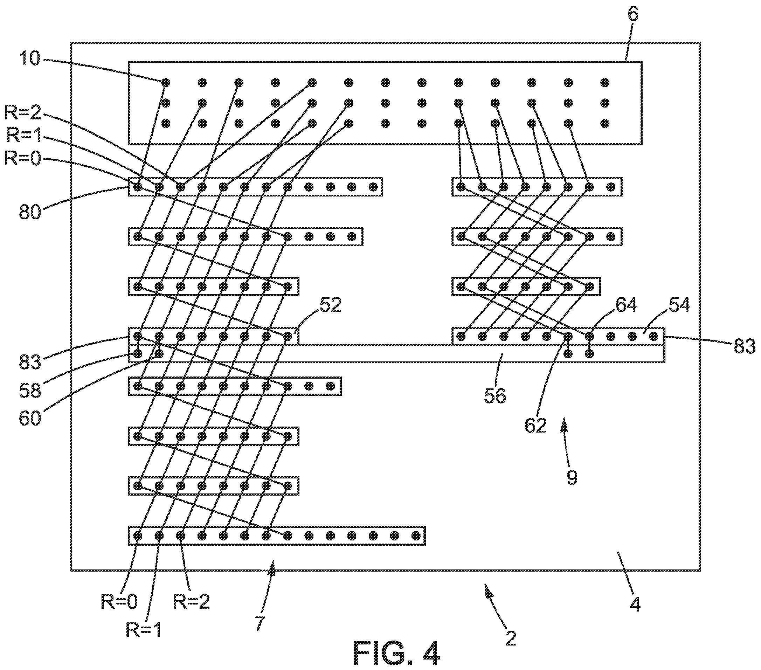

La figure 4 représente une partie du circuit électronique 20, lorsque celui-ci est utilisé pour réaliser une fonction de redondance. Sur cette figure, une carte d'extension 52 est enfichée sur le quatrième connecteur d'extension 83 du premier ensemble. Les composants électroniques de cette carte d'extension 52 sont connectés aux contacts d'extension 58, 60 identifiés par R=0 et R=1 du connecteur d'extension identifié par S=3 du premier ensemble. Une carte d'extension 54 est enfichée sur le connecteur d'extension 83 du deuxième ensemble 9. Les composants électroniques de cette carte d'extension 54 sont connectés aux contacts d'extension 62, 64 identifiés par R=5 et R=6 du connecteur d'extension identifié par S=3 du deuxième ensemble. Les cartes d'extension 52 est 54 sont propres à mettre en œuvre la même fonction, par exemple une mesure de tension. Une carte d'extension 56 est connectée, d'une part, aux contacts d'extension 58, 60 du connecteur d'extension du premier ensemble et, d'autre part, aux contacts d'extension 62, 64 du connecteur d'extension du deuxième ensemble. Cette carte d'extension comporte une première liaison électrique reliant électriquement le contact d'extension 58 au contact d'extension 62 et une deuxième liaison électrique reliant électriquement le contact d'extension 60 au contact d'extension 64.

Ainsi, avantageusement, la mesure de tension est réalisée en redondance sur la carte d'extension 52 et sur la carte d'extension 54 à partir des mêmes signaux électrique puisque la carte d'extension 56 permet la transmission des données d'une carte à l'autre.

Avantageusement, un tel système permet de simplifier le harnais pour réaliser des fonctions de redondance. En effet, la réalisation des harnais est coûteuse et source d'erreur.

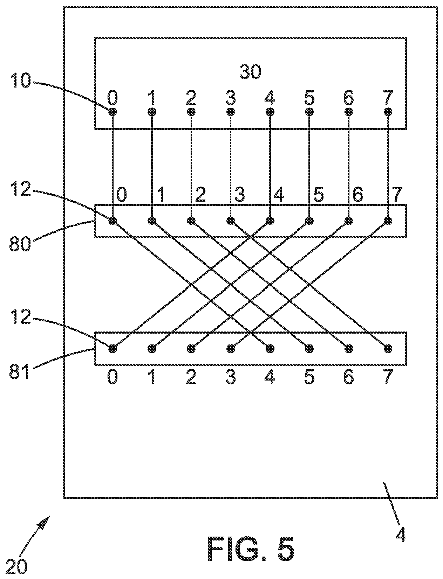

En référence à la figure 5, un autre exemple de réalisation d'un circuit électronique 20 selon invention comporte une carte mère 4, une unité de calcul principale 30, un premier connecteur d'extension 80 et un deuxième connecteur d'extension 81.

L'unité de calcul 30 comporte huit contacts d'entrée/sortie 10 identifiés de T= 0 à T= 7. N est égal à 8.

Le premier connecteur d'extension 80 est identifié par l'identifiant S=0. Il est comporte huit contacts d'extension 12 identifiés de gauche à droite par des identifiants de R = 0 à R= 7.

Le deuxième connecteur d'extension 81 est identifié par l'identifiant S=1. Il est comporte huit contacts d'extension 12 identifiés de gauche à droite par des identifiants de R = 0 à R= 7.

Selon ce mode de réalisation, La relation (1) décrit les liaisons électriques entre deux connecteurs d'extension et l'unité de calcul 30. Selon la présente demande on dira que le connecteur d'entrée/sortie fait partie de l'unité de calcul 30 ou est intégré à celle-ci.

Les contacts d'entrée/sortie 10 de l'unité de calcul 30 sont reliés électriquement aux contacts d'extension 12 du premier connecteur d'extension 80 et du deuxième connecteur d'extension 81 de telle manière que la relation (1) soit vérifiée avec, dans ce cas, N =8 et D= 4.

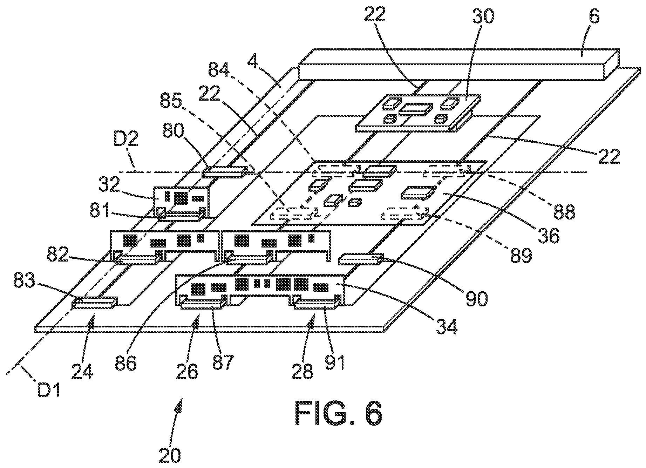

En référence à la figure 6, un troisième exemple de circuit électronique 20 selon l'invention comporte une carte mère 4, un connecteur d'entrée/sortie 6, trois liaisons électriques d'entrée/sortie 22 connectées au connecteur d'entrée/sortie 6 et des connecteurs d'extension 80 à 91 reliés électriquement aux liaisons électriques 22.

Tout comme pour le premier mode de réalisation de l'invention, le connecteur d'entrée/sortie 6 comporte des contacts d'entrée/sortie identifiés par l'identifiant T. Ces contacts d'entrée/sortie ne sont pas représentés sur la figure 6.

Les connecteurs d'extension 80 à 91 sont des connecteurs femelles de type barrette. Les connecteurs d'extension 80 à 91 sont identifiés par un identifiant S.

Les connecteurs d'extension 80 à 91 comprennent des contacts d'extension identifiés par un identifiant R. Ces contacts d'extension ne sont pas représentés sur la figure 6.

Les liaisons électriques d'entrée/sortie 22 sont propres à transmettre les données d'entrée/sortie entre les contacts d'entrée/sortie du connecteur d'entrée/sortie 6 et les contacts d'extension des connecteurs d'extension 80 à 91.

Les liaisons électriques d'entrée/sortie 22 sont formées sur la carte mère 4 de manière à s'étendre sensiblement parallèlement les unes aux autres.

Dans le mode de réalisation représenté, les liaisons électriques d'entrée/sortie 22 s'étendent également ment perpendiculairement au connecteur d'entrée/sortie 6.

Dans le mode de réalisation représenté, quatre connecteurs d'extension 80, 81, 82, 83 sont reliés électriquement entre eux et au connecteur d'entrée/sortie 6 par une première liaison électrique 22. Ces quatre connecteurs d'extension 80, 81, 82, 83 forment un premier ensemble 24.

Quatre connecteurs d'extension 84, 85, 86, 87 sont reliés électriquement entre eux et au connecteur d'entrée/sortie 6 par une deuxième liaison électrique 22. Ces quatre connecteurs d'extension 84, 85, 86, 87 forment un deuxième ensemble 26.

De même, quatre connecteurs d'extension 88, 89, 90, 91 sont reliés électriquement entre eux et au connecteur d'entrée/sortie 6 par une troisième liaison électrique 22. Ils forment un troisième ensemble 28.

Selon la présente invention, dans chaque ensemble, des contacts d'entrée/sortie d'identifiant T sont, chacun, reliés électriquement à un contact d'extension d'identifiant R d'un connecteur d'extension d'identifiant S, avec l'identifiant T satisfaisant la relation (1).

Avantageusement, selon ce mode de réalisation, les connecteurs d'extension 80 à 91 sont disposés sur la carte électronique mère 4 selon un arrangement en quadrillage. Ainsi, les connecteurs d'extension 80, 81, 82, 83 du premier ensemble sont disposés selon une première droite rectiligne D1. Le premier connecteur d'extension 80 (connecteur directement relié au connecteur d'entrée/sortie 6), du premier ensemble 24, le premier connecteur d'extension 84 (connecteur directement relié au connecteur d'entrée/sortie 6) du deuxième ensemble 26 et le premier connecteur d'extension 88 du troisième ensemble 28 sont alignés selon une seconde droite rectiligne D2 perpendiculaire à la première droite rectiligne D1. De la même façon, le troisième connecteur d'extension 82 du premier ensemble 24, (c'est-à-dire le connecteur d'extension directement relié au premier connecteur d'extension 80), le deuxième connecteur d'extension 85 du deuxième ensemble et le deuxième connecteur d'extension 89 du troisième ensemble sont alignés selon une droite perpendiculaire à la première droite D1.

Le circuit électronique 20 comporte en outre une unité de calcul principale 30 de type processeur, des cartes d'extension 32, 34, 36 connectées aux connecteurs d'extension 80 à 91 et des liaisons d'extension 36 reliant les connecteurs d'extension 80 à 91 à l'unité de calcul principale 30.

La carte d'extension 32 est enfichée dans le connecteur d'extension 81. Elle s'étend dans un plan perpendiculaire au plan principal de la carte mère 4.

La carte d'extension 34 est enfichée dans deux connecteurs d'extension 87 et 91 et elle s'étend entre ceux-ci. Elle s'étend dans un plan perpendiculaire au plan principal de la carte mère 4.

La carte d'extension 36 est enfichée dans quatre connecteurs d'extension 84, 88, 85 et 89. Elle s'étend dans un plan parallèle au plan principal de la carte mère 4. Des connecteurs males/femelles sont enfichés entre la carte d'extension 36 et les connecteurs d'extension 84, 88, 85, 89.

Avantageusement, cette carte électronique peut être utilisée de manière standard pour réaliser différentes fonctions sans nécessiter la fabrication d'une nouvelle carte électronique. La carte électronique selon la présente invention peut s'adapter à la mise en œuvre de différentes fonctions. Grâce à la présente invention, il n'est plus nécessaire de réaliser des cartes électroniques sur mesure, c'est-à-dire de prévoir à l'avance la totalité des fonctions à réaliser et de réaliser la carte électronique en fonction de la totalité de ses fonctions.

**Revendications**

1. Circuit électronique (2, 20) comprenant :

   a) une carte électronique mère (4),
   b) un connecteur d'entrée/sortie (6) fixé sur la carte électronique mère (4), ledit connecteur d'entrée/sortie (6) comprenant au moins un groupe (601, 602, 603) comportant N contacts d'entrée/sortie (10), N étant un entier naturel supérieur ou égal à 2 ;
   c) au moins un ensemble (7, 9, 11, 24, 26, 28) comportant des connecteurs d'extension (80 à 91) fixés sur la carte électronique mère (4), chaque connecteur d'extension (80 à 91) du au moins un ensemble (7, 9, 11, 24, 26, 28) ayant des contacts d'extension (12') connectés électriquement à des contacts d'entrée/sortie (10) du au moins un groupe (601, 602, 603) ;

   chaque contact d'entrée/sortie (10) du au moins un groupe étant identifié par un identifiant T, chaque connecteur d'extension (80 à 91) du au moins un ensemble (7, 9, 11, 24, 26, 28) étant identifié par un identifiant S, chaque contact d'extension connecté (12') étant identifié par un identifiant R, les identifiants T, R et S étant des nombres entiers naturels supérieur ou égale à 0; **caractérisé en ce que**, pour :

   • chaque connecteur d'extension (80 à 91) d'identifiant S du au moins un ensemble (7, 9, 11, 24, 26, 28), et
   • chaque contact d'extension connecté (12') d'identifiant R,

   chaque contact d'entrée/sortie (10) d'identifiant T du au moins un groupe (601, 602, 603) est relié électriquement à un unique contact d'extension (12') d'identifiant R du connecteur d'extension (81 à 92) d'identifiant S du au moins un groupe (601, 602, 603), et **en ce que**
   l'identifiant T du contact d'entrée/sortie (10) du au moins un groupe (601, 602, 603) est calculé en fonction des identifiants R et S selon la relation suivante :

$$T = [(R + D \times S) \bmod (N)]$$

avec D fixé dans chaque groupe et sous multiple entier de l'entier naturel N, où le choix de D est fonction du nombre de broches de contact qui seront connectées pour réaliser une fonction.

2. Circuit électronique (2, 20) selon la revendication 1, qui comporte au moins une carte d'extension (32, 34, 38, 40, 42, 52, 54, 56) comprenant au moins un composant électronique (46, 48, 50) et au moins une broche de contact (44) reliée électriquement audit composant électronique (46, 48, 50), ladite au moins une broche de contact (44) étant disposée à une extrémité de la carte d'extension (32, 34, 38, 40, 42, 52, 54, 56) et enfichée dans au moins un contact d'extension (12') d'au moins un connecteur d'extension (80 à 91), et dans lequel l'entier naturel D est inférieur ou égal audit nombre broche de contact (44).

3. Circuit électronique (2, 20) selon la revendication 2, dans lequel ledit au moins un composant électronique (46, 48, 50) est relié à plusieurs broches de contact (44), lesdites broches de contact (44) étant situées les unes directement adjacentes aux autres.

4. Circuit électronique (2, 20) selon l'une quelconque des revendications 1 à 3, dans lequel les contacts d'extension (12') sont identifiés par des identifiants selon un ordre croissant de gauche à droite ou de droite à gauche et dans lequel le connecteur d'extension connecté directement au connecteur d'entrée/sortie (6), dit premier connecteur d'extension (80), présente un identifiant S égal à 0, ledit connecteur d'extension (81) directement relié audit premier connecteur d'extension (80) ayant un identifiant S égal à 1.

5. Circuit électronique (2, 20) selon l'une quelconque des revendications 1 à 4, dans lequel l'identifiant S varie entre 0 et au moins (N / D) - 1.

6. Circuit électronique (2, 20) selon l'une quelconque des revendications 1 à 5, dans lequel l'entier naturel D est égal à 1.

7. Circuit électronique (2, 20) selon l'une quelconque des revendications 1 à 5, dans lequel l'entier naturel D est égal à 2.

8. Circuit électronique (2, 20) selon l'une quelconque des revendications 1 à 5, dans lequel l'entier naturel D est égal à 4.

9. Circuit électronique (20) selon l'une quelconque des revendications 1 à 4, dans lequel le connecteur d'entrée/sortie (6) est intégré à l'unité de calcul (30).

10. Circuit électronique (2, 20) selon l'une quelconque des revendications 1 à 9, qui comporte au moins deux ensembles (7, 9, 11, 24, 26, 28), les contacts d'extension (12') d'un ensemble (7, 9, 11, 24, 26, 28) étant reliés électriquement aux contacts d'entrée/sortie (10) d'un groupe (601, 602 603), et dans lequel les connecteurs d'extension (81 à 91) sont disposés sur la carte électronique mère (4) selon un arrangement en quadrillage, lesdits connecteurs d'extension (81 à 91) d'un même ensemble (7, 9, 11, 24, 26, 28) étant alignés le long d'une première droite rectiligne (D1); au moins deux connecteurs d'extension de deux ensembles distincts (7, 9, 11, 24, 26, 28) étant alignés le long d'une seconde droite rectiligne (D2) qui s'étend perpendiculairement à la première droite rectiligne (D1).

11. Circuit électronique (2, 20) selon l'une quelconque des revendications 1 à 10, qui comporte au moins une carte d'extension (32, 34, 36) enfichée dans au moins un connecteur d'extension (8, 81 à 91), ladite carte d'extension (81 à 91) s'étendant perpendiculairement à la carte mère (4).

12. Circuit électronique (2, 20) selon l'une quelconque des revendications 1 à 10, qui comporte au moins une carte d'extension (32, 34, 36) enfichée dans au moins un connecteur d'extension (81 à 91), ladite carte d'extension (32, 34, 36) s'étendant parallèlement à la carte mère (4).

**Patentansprüche**

1. Elektronische Schaltung (2, 20), umfassend:

    a) eine elektronische Hauptplatine (4),
    b) einen Eingangs-/Ausgangsverbinder (6), der an der elektronischen Hauptplatine (4) befestigt ist, wobei der Eingangs-/Ausgangsverbinder (6) wenigstens eine Gruppe (601, 602, 603), umfassend N Eingangs-/Ausgangskontakte (10) aufweist, wobei N eine natürliche Zahl gleich oder größer 2 ist;
    c) wenigstens eine Anordnung (7, 9, 11, 24, 26, 28), umfassend Erweiterungsverbinder (80 bis 91), die auf der elektronischen Hauptplatine (4) befestigt sind, wobei jeder Erweiterungsverbinder (80 bis 91) der wenigstens einen Anordnung (7, 9, 11, 24, 26, 28) Erweiterungskontakte (12') aufweist, die elektrisch mit Eingangs-/Ausgangskontakten (10) der wenigstens einen Gruppe (601, 602, 603) verbunden sind;
    wobei jeder Eingangs-/Ausgangskontakt (10) der wenigstens einen Gruppe durch eine Kennung T gekennzeichnet ist, wobei jeder Erweiterungsverbinder (80 bis 91) der wenigstens einen Anordnung (7, 9, 11, 24, 26, 28) durch eine Kennung S gekennzeichnet ist, wobei jeder verbundene Erweiterungskontakt (12') durch eine Kennung R gekennzeichnet ist, wobei die Kennungen T, R und S natürliche Zahlen größer oder gleich 0 sind; **dadurch gekennzeichnet, dass** für:

• jeden Erweiterungsverbinder (80 bis 91) der Kennung S der wenigstens einen Anordnung (7, 9, 11, 24, 26, 28) und
• jeden verbundenen Erweiterungskontakt (12') der Kennung R,

jeder Eingangs-/Ausgangskontakt (10) der Kennung T der wenigstens einen Gruppe (601, 602, 603) elektrisch mit einem einzelnen Erweiterungskontakt (12') der Kennung R des Erweiterungskontakt (12') der Kennung R des Erweiterungsverbinders (81 bis 92) der Kennung S der wenigstens einen Gruppe (601, 602, 603) verbunden ist, und dass die Kennung T des Eingangs-/Ausgangskontakts (10) der wenigstens einen Gruppe (601, 602, 603) in Abhängigkeit von den Kennungen R und S gemäß der folgenden Beziehung berechnet wird:

$$T = [(R + D \times S) \text{ modulo } (N)]$$

wobei D in jeder Gruppe festgelegt ist und einem ganzzahligen Untervielfachen der natürlichen Zahl N entspricht, wobei die Wahl von D eine Funktion der Anzahl der Kontaktstifte ist, die zur Ausführung einer Funktion angeschlossen sind.

2. Elektronische Schaltung (2, 20) nach Anspruch 1, welche wenigstens eine Erweiterungsplatine (32, 34, 38, 40, 42, 52, 54, 56) aufweist, umfassend wenigstens eine elektronische Komponente (46, 48, 50) und wenigstens einen mit der elektronischen Komponente (46, 48, 50) elektrisch verbundenen Kontaktstift (44) aufweist, wobei der wenigstens eine Kontaktstift (44) an einem Ende der Erweiterungsplatine (32, 34, 38, 40, 42, 52, 54, 56) angeordnet und in wenigstens einen Erweiterungskontakt (12') wenigstens eines Erweiterungsverbinders (80 bis 91) eingesteckt ist und wobei die natürliche Zahl D kleiner oder gleich der Anzahl der Kontaktstifte (44) ist.

3. Elektronische Schaltung (2, 20) nach Anspruch 2, wobei die wenigstens eine elektronische Komponente (46, 48, 50) mit mehreren Kontaktstiften (44) verbunden ist, wobei die Kontaktstifte (44) direkt zueinander benachbart angeordnet sind.

4. Elektronische Schaltung (2, 20) nach einem der Ansprüche 1 bis 3, wobei die Erweiterungskontakte (12') durch Kennungen in aufsteigender Reihenfolge von links nach rechts oder von rechts nach links gekennzeichnet sind und wobei der direkt mit dem Eingangs-/Ausgangsverbinder (6) verbundene Erweiterungsverbinder (80) eine Kennung S gleich 0 hat, wobei der direkt mit dem ersten Erweiterungsverbinder (80) verbundene Erweiterungsverbinder (81) eine Kennung S gleich 1 hat.

5. Elektronische Schaltung (2, 20) nach einem der Ansprüche 1 bis 4, wobei die Kennung S zwischen 0 und wenigstens (N / D) - 1 variiert.

6. Elektronische Schaltung (2, 20) nach einem der Ansprüche 1 bis 5, wobei die natürliche Zahl D gleich 1 ist.

7. Elektronische Schaltung (2, 20) nach einem der Ansprüche 1 bis 5, wobei die natürliche Zahl D gleich 2 ist.

8. Elektronische Schaltung (2, 20) nach einem der Ansprüche 1 bis 5, wobei die natürliche Zahl D gleich 4 ist.

9. Elektronische Schaltung (20) nach einem der Ansprüche 1 bis 4, wobei der Eingangs-/Ausgangsverbinder (6) in der Recheneinheit (30) integriert ist.

10. Elektronische Schaltung (2, 20) nach einem der Ansprüche 1 bis 9, welche wenigstens zwei Anordnungen (7, 9, 11, 24, 26, 28) umfasst, wobei die Erweiterungskontakte (12') einer Anordnung (7, 9, 11, 24, 26, 28) elektrisch mit den Eingangs-/Ausgangskontakten (10) einer Gruppe (601, 602 603) verbunden sind, und wobei die Erweiterungsverbinder (81 bis 91) auf der elektronischen Hauptplatine (4) in einer Gitteranordnung angeordnet sind,
wobei die Erweiterungsverbinder (81 bis 91) derselben Anordnung (7, 9, 11, 24, 26, 28) entlang einer ersten geraden Linie (D1) ausgerichtet sind; wobei wenigstens zwei Verlängerungsverbinder von zwei getrennten Anordnungen (7, 9, 11, 24, 26, 28) entlang einer zweiten geraden Linie (D2) ausgerichtet sind, die sich senkrecht zu der ersten geraden Linie (D1) erstreckt.

11. Elektronische Schaltung (2, 20) nach einem der Ansprüche 1 bis 10, welche wenigstens eine Erweiterungsplatine (32, 34, 36) aufweist, die in wenigstens einen Erweiterungsverbinder (8, 81 bis 91) eingesteckt ist, wobei sich die Erweiterungsplatine (81 bis 91) senkrecht zur Hauptplatine (4) erstreckt.

12. Elektronische Schaltung (2, 20) nach einem der Ansprüche 1 bis 10, welche wenigstens eine Erweiterungsplatine (32, 34, 36) aufweist, die in wenigstens einen Erweiterungsverbinder (81 bis 91) eingesteckt ist, wobei sich die Erweiterungsplatine (32, 34, 36) parallel zur Hauptplatine (4) erstreckt.

**Claims**

1. Electronic circuit 2, 20) comprising:

   a) a motherboard (4),
   b) an input/output connector (6) mounted on the motherboard (4), said input/output connector (6) comprising at least one group (601, 602, 603) containing N input/output contacts (10), N being a natural number greater than or equal to 2;
   c) at least one set(7, 9, 11, 24, 26, 28) containing expansion slots (80 to 91) mounted on the motherboard (4), each expansion slot (80 to 91) of the at least one set (7, 9, 11, 24, 26, 28) having expansion contacts (12') electrically connected to input/output contacts (10) of the at least one group (601, 602, 603);

   each input/output contact (10) of the at least one group being identified by an identifier T, each expansion slot (80 to 91) of the at least one set (7, 9, 11, 24, 26, 28) being identified by an identifier S, each connected expansion contact (12') being identified by an identifier R, the identifiers T, R, and S being natural numbers greater than or equal to 0;
   **characterized in that**, for:

   • each expansion slot80 to 91) of identifier S of the at least one set (7, 9, 11, 24, 26, 28), and
   • each connected expansion contact (12') of identifier R,

   each input/output contact (10) of identifier T of the at least one group (601, 602, 603) is electrically connected to a single expansion contact (12') of identifier R of the expansion slot (81 to 92) of identifier S of the at least one group (601, 602, 603), and **in that** the identifier T of the input/output contact (10) of the at least one group (601, 602, 603) is calculated as a function of the R and S identifiers, according to the following relation:

   $$T = [(R + D \times S) \bmod (N)]$$

   where D is fixed in each group and is an integer submultiple of the natural number N, where the choice of D is based on the number of contact pins that will be connected in order to implement a function.

2. Electronic circuit (2, 20) according to claim 1, including at least one expansion card (32, 34, 38, 40, 42, 52, 54, 56) comprising at least one electronic component (46, 48, 50) and at least one contact pin (44) electrically connected to said electronic component (46, 48, 50), said at least one contact pin (44) being arranged at one end of the expansion card (32, 34, 38, 40, 42, 52, 54, 56) and inserted into at least one expansion contact (12') of at least one expansion slot (80 to 91), and wherein the natural number D is less than or equal to said contact pin (44) number.

3. Electronic circuit (2, 20) according to claim 2, wherein said at least one electronic component (46, 48, 50) is connected to multiple contact pins (44), said contact pins (44) being directly adjacent to one another.

4. Electronic circuit(2, 20) according to any one of claims 1 to 3, wherein the expansion contacts (12') are identified by identifiers in ascending order from left to right or from right to left, and wherein the expansion slot connected directly to the input/output connector (6), referred to as the first expansion slot (80), has an identifier S equal to 0, said expansion slot (81) directly connected to said first expansion slot (80) having an identifier S equal to 1.

5. Electronic circuit (2, 20) according to any one of claims 1 to 4, wherein the identifier S varies between 0 and at least (N/D) - 1.

6. Electronic circuit 2, 20) according to any one of claims 1 to 5, wherein the natural number D is equal to 1.

7. Electronic circuit (2, 20) according to any one of claims 1 to 5, wherein the natural number D is equal to 2.

8. Electronic circuit (2, 20) according to any one of claims 1 to 5, wherein the natural number D is equal to 4.

9. Electronic circuit (20) according to any one of claims 1 to 4, wherein the input/output connector (6) is integrated into the calculation unit (30).

10. Electronic circuit (2, 20) according to any one of claims 1 to 9, having at least two sets (7, 9, 11, 24, 26, 28), the expansion contacts (12') of a set (7, 9, 11, 24, 26, 28) being electrically connected to the input/output contacts (10) of a group (601, 602 603), and wherein the expansion slots (81 to 91) are arranged on the motherboard (4) in a grid arrangement,
    said expansion slots (81 to 91) of a same set (7, 9, 11, 24, 26, 28) being aligned along a first straight line (D1); at least two expansion slots of two different sets (7, 9, 11, 24, 26, 28) being aligned along a second straight line (D2) extending perpendicularly to the first straight line (D1).

11. Electronic circuit (2, 20) according to any one of claims 1 to 10, having at least one expansion card (32, 34, 36) inserted into at least one expansion slot (8, 81 to 91), said expansion card (81 to 91) extending perpendicularly to the motherboard (4).

12. Electronic circuit (2, 20) according to any one of claims 1 to 10, having at least one expansion card (32, 34, 36) inserted into at least one expansion slot (81 to 91), said expansion card (32, 34, 36) extending parallel to the motherboard (4).

FIG. 1

FIG. 2

FIG. 3

FIG. 4

FIG. 5

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2448390 A

- US 2014004723 A